(19) Europäisches Patentamt
European Patent Office
Office européen des brevets

(11) **EP 2 234 122 B1**

(12) **EUROPÄISCHE PATENTSCHRIFT**

(45) Veröffentlichungstag und Bekanntmachung des Hinweises auf die Patenterteilung:
**20.07.2011 Patentblatt 2011/29**

(51) Int Cl.:
***H01B 12/06*** *(2006.01)*

(21) Anmeldenummer: **09290218.8**

(22) Anmeldetag: **25.03.2009**

(54) **Supraleitfähiges elektrisches Kabel**

Superconducting electrical cable

Câble supraconducteur électrique

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**

(43) Veröffentlichungstag der Anmeldung:
**29.09.2010 Patentblatt 2010/39**

(73) Patentinhaber: **Nexans**
**75008 Paris (FR)**

(72) Erfinder:
• **Soika, Rainer, Dr.**
**30559 Hannover (DE)**
• **Schmidt, Frank, Dipl.-Ing.**
**30856 Langenhagen (DE)**

(74) Vertreter: **Döring, Roger**
**Patentanwalt**
**Weidenkamp 2**
**30855 Langenhagen (DE)**

(56) Entgegenhaltungen:
**EP-A- 0 650 205     EP-A- 1 821 380**
**DE-A1- 3 928 085     GB-A- 1 421 044**

**Beschreibung**

Die Erfindung betrifft ein supraleitfähiges elektrisches Kabel gemäß dem Oberbegriff des Patentanspruchs 1.

Ein solches Kabel geht aus der WO 03/052775 A1 hervor.

Ein supraleitfähiges Kabel hat in heutiger Technik elektrische Leiter aus einem Verbundwerkstoff, welcher keramisches Material enthält, das bei ausreichend tiefen Temperaturen in den supraleitfähigen Zustand übergeht. Der elektrische -Gleichstromwiderstand eines entsprechend aufgebauten Leiters ist bei ausreichender Kühlung Null, solange eine bestimmte Stromstärke, die kritische Stromstärke, nicht überschritten wird. Geeignete keramische Materialien sind beispielsweise oxidische Materialien auf Basis seltener Erden (ReBCO), insbesondere YBCO (Yttrium-Barium-Kupfer-Oxid), oder BSCCO (Wismut-Strontium-Kalzium-Kupfer-Oxid). Ausreichend niedrige Temperaturen, um ein derartiges Material in den supraleitfähigen Zustand zu bringen, liegen beispielsweise zwischen 67 K und 110 K. Geeignete Kühlmittel sind beispielsweise Stickstoff, Helium, Neon und Wasserstoff oder Gemische dieser Stoffe.

Aus der EP 0 650 205 A1 geht ein supraleitfähiges Kabel gemäß dem Oberbegriff des Anspruch 1 hervor, dessen supraleitfähiger Leiter um einen biegbaren Träger herumgeformt ist. Der Träger kann als Balgenrohr mit vorgegebener Wandstärke und Balgentiefe ausgeführt sein. Er kann auch aus einem Stahlband bestehen, das als Spirale gewickelt ist. In allen Ausführungsformen hat der Träger auf seiner ganzen Länge einen konstant bleibenden Durchmesser.

Das bekannte Kabel nach der eingangs erwähnten WO 03/052775 A1 hat einen supraleitfähigen Leiter, der in mindestens einer Lage um ein Rohr herumgeformt ist. Zu dem Kabel gehören weitere, den Leiter umgebende Schichten. Es ist unter Freilassung eines Freiraums in einem aus zwei koaxial zueinander angeordneten metallischen Rohren, zwischen denen sich eine Vakuumisolierung befindet, bestehenden Kryostat angeordnet. Ein den supraleitfähigen Zustand des Leiters bewirkendes Kühlmittel kann durch das Rohr und durch den Freiraum des Kryostats geleitet werden.

Der Leiter eines supraleitfähigen Kabels besteht in bekannter Technik aus Bändern oder Drähten aus supraleitfähigem Material, die in mindestens einer Lage um einen Träger, beispielsweise um ein Rohr, herumgewickelt sind. Durch die zum Betrieb des Kabels erforderliche Abkühlung des Leiters von Raumtemperatur auf die für den supraleitfähigen Zustand benötigte Temperatur schrumpft das supraleitfähige Leitermaterial etwa um 0,25 % bis 0,3 %. Das kann bei einer Kabellänge von beispielsweise 600 m zu einer Verkürzung des Leiters um etwa 1,5 m bis 1,8 m führen. Das supraleitfähige Kabel und damit auch sein Leiter ist an seinen Enden in Anschlußarmaturen festgelegt. Die durch die Abkühlung erhebliche Verkürzung des Leiters führt zu einer erheblichen Zugbelastung der Anschlußarmaturen. Sie kann außerdem leicht zu einer Überdehnung des Leiters bzw. seiner Einzelelemente und damit zu einer Beschädigung führen, durch welche der Leiter unbrauchbar wird. Um derartige Auswirkungen auf die Funktionsfähigkeit des Leiters zu verhindern, sollen seine Enden gemäß der EP 1 821 380 B1 beispielsweise erst nach erfolgter Abkühlung und damit in einer dem supraleitfähigen Zustand entsprechenden, verkürzten Länge innerhalb des Kryostats fixiert werden. Der Aufwand für diese Maßnahme ist relativ hoch. Wenn ein solches supraleitfähiges Kabel beispielsweise für Reparaturzwecke auf Raumtemperatur erwärmt wird, werden die Anschlußarmaturen außerdem durch das sich ausdehnende Kabel mechanisch belastet.

Der Erfindung liegt die Aufgabe zugrunde, das eingangs geschilderte Kabel so zu gestalten, daß temperaturbedingte Längenänderungen des Leiters auf einfache Weise ausgeglichen werden können.

Diese Aufgabe wird gemäß dem kennzeichnenden Merkmal des Patentanspruchs 1 gelöst.

Bei diesem Kabel ist das als Träger des Leiters eingesetzte Rohr elastisch so verformbar, daß sein Durchmesser sich bei einer von außen einwirkenden radialen Druckbelastung verringern kann. Das wird durch den sich in Längsrichtung des Rohres erstreckenden Spalt sichergestellt, der bei Raumtemperatur ausreichend breit bemessen ist, damit er sich während der Abkühlung des Leiters verengen bzw. maximal ganz schließen kann. Die während der Abkühlung erfolgende Verkürzung des Leiters wirkt sich damit im wesentlichen in radialer Richtung auf seinen Träger aus, so daß auf die Anschlußarmaturen an den Enden des Kabels keine wesentlichen Zugbelastungen ausgeübt werden. Da das Rohr elastisch verformbar ist, weitet sich der Spalt bei Reduzierung oder im Extremfall Fortfall der radialen Belastung des Rohres wieder auf, so daß der Durchmesser des Rohres wieder größer wird. Der Leiter des supraleitfähigen Kabels liegt dadurch unabhängig von seiner Länge beim Abkühlen oder beim Wärmerwerden ständig an der Oberfläche des damit dauernd als Träger wirkenden Rohres an. Die Worte "elastisch verformbar" bedeuten im Sinne der Erfindung, daß das Rohr ständig gegen den dasselbe umgebenden Leiter drückt, also im weitesten Sinne federnde Eigenschaften hat.

Die Breite des Spaltes, die für ein in obigem Sinne wirkendes Rohr bei Raumtemperatur benötigt wird, kann in Abhängigkeit vom Durchmesser des Rohres, vom Material desselben und von der Differenz zwischen Raumtemperatur und Arbeitstemperatur des Kabels im supraleitfähigen Zustand berechnet bzw. vorgegeben werden.

Ausführungsbeispiele des Erfindungsgegenstandes sind in den Zeichnungen dargestellt.

Es zeigen:

Fig. 1 einen Querschnitt einer Anordnung mit einem supraleitfähigen Kabel.

Fig. 2 einen für ein supraleitfähiges Kabel nach der Erfindung einsetzbares Rohr als Träger für den Leiter des Kabels.

Fig. 3 eine gegenüber Fig. 2 abgewandelte Ausführungsform des Rohres.

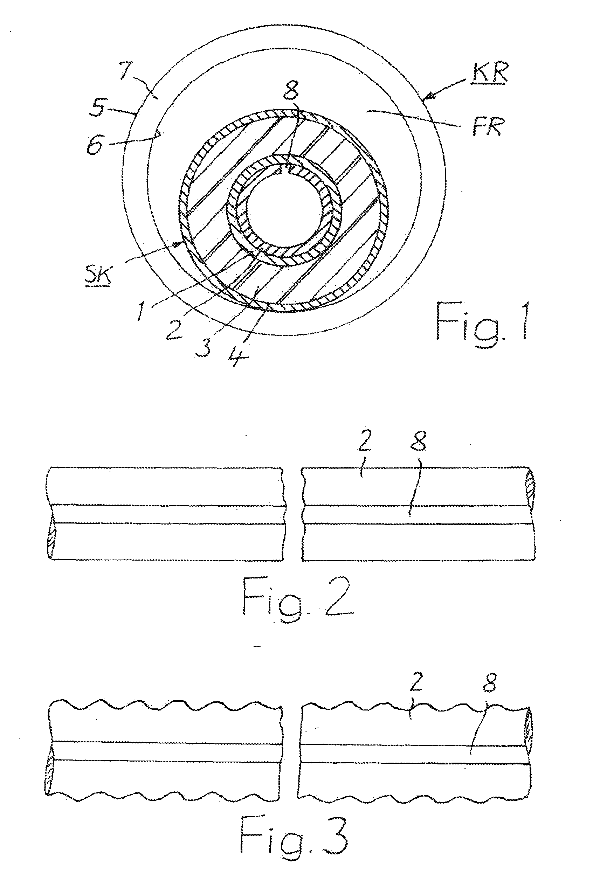

In Fig. 1 ist ein prinzipieller Aufbau eines in einem Kryostat KR angeordneten supraleitfähigen Kabels SK dargestellt. Das Kabel SK hat einen supraleitfähigen Leiter 1, der um ein als Träger ausgeführtes Rohr 2 herumgeformt ist. Der Leiter 1 ist von einem Dielektrikum 3 umgeben, über welchem ein supraleitfähiger Schirm 4 angeordnet ist. Der Kryostat KR besteht aus zwei koaxial zueinander angeordneten metallischen Rohren 5 und 6, zwischen denen sich eine Vakuumisolierung 7 befindet. Der Kryostat KR umschließt das Kabel SK und einen Freiraum FR zum Durchleiten eines Kühlmittels.

Die Rohre 5 und 6 des Kryostats KR bestehen mit Vorteil aus Edelstahl. Sie können quer zu ihrer Längsrichtung gewellt sein. Leiter 1 und Schirm 4 können aus üblichen supraleitfähigen Materialien bestehen, insbesondere aus den eingangs erwähnten Materialien YBCO und BSCCO. Der Leiter 1 besteht mit Vorteil aus supraleitfähigen Bändern oder Drähten, die in mindestens einer Lage um das Rohr 2 herumgewickelt sind. Das Dielektrikum 3 ist in üblicher Technik aufgebaut. Das Kabel SK ist in der Ausführungsform nach Fig. 1 ein supraleitfähiges Kabel mit kaltem Dielektrikum.

Das als Träger für den Leiter 1 verwendete Rohr 2 ist im weiter oben geschilderten Sinne elastisch verformbar, und zwar in radialer Richtung mit veränderbarem Durchmesser. Das Rohr 2 besteht in bevorzugter Ausführungsform aus Edelstahl, Kupfer oder Aluminium bzw. deren Legierungen. Es kann mit Vorteil beispielsweise aus einer Beryllium-Kupfer-Legierung bestehen. Es kann entsprechend Fig. 3 quer zu seiner Längsrichtung gewellt sein. Das Rohr 2 hat einen sich über seine ganze Länge erstreckenden Spalt 8, der gemäß den Fig. 2 und 3 geradlinig entlang einer Mantellinie des Rohres verläuft.

**Beispiel**

Die Breite des Spaltes 8 kann beispielsweise wie folgt berechnet werden:

Wenn ein Leiter mit einer Schlaglänge LS um einen Strang mit dem Durchmesser D verseilt wird, ist die Leiterlänge L pro Schlaglänge LS durch die Gleichung $L = \sqrt{LS^2 + \pi^2 D^2}$ gegeben. Wenn der Leiter abgekühlt wird, wird er durch Schrumpfung insbesondere kürzer. Diese Schrumpfung kann dadurch kompensiert werden, daß eine Reduzierung des Durchmessers des aus dem aufgewickelten Leiter bestehenden

Wickelkörpers ermöglicht wird. Dies wird erreicht, wenn für die Länge LK des kalten Leiters folgendes gilt: LK = αL. α ist dabei ein Faktor, der von der thermischen Kontraktion des Materials des Stranges abhängt. Metallische Materialien schrumpfen beispielsweise um etwa 0,3%, wenn sie von Raumtemperatur auf 77 K abgekühlt werden. In einem solchen Falle wäre α= 1-0,003=0,997. Aus der oben angegeben Gleichung folgt, daß für

$$L = \sqrt{LS^2 + \pi^2 D^2} \times \alpha = \sqrt{L^2 + \pi^2 DK^2} \quad \text{ein}$$

Durchmesser DK bestimmt werden kann, auf den der Wickelkörper des geschrumpften Leiters im kalten Zustand schrumpfen sollte.

In dem supraleitfähigen Kabel SK soll der Leiter beispielsweise um ein aus Edelstahl bestehendes Rohr 2 mit einem Durchmesser von 25 mm herumgewickelt sein. Die Schlaglänge LS soll das zehnfache des Durchmessers betragen, also LS = 250 mm. Mit einem Faktor α von 0,997 ergibt sich dann ein Durchmesser DK des kalten Rohres 2 von 24,58 mm. Ein solcher Durchmesser entspricht einem Umfang des Rohres 2 von 77,22 m. Im Originalzustand war der Umfang desselben - bei einem Durchmesser von D = 25 mm - 78,54 mm. Wenn auch das Rohr 2 radial um 0,3 % schrumpft, dann ist der Durchmesser desselben im abgekühlten Zustand 25 mm x 0,997 = 24,93 mm. Sein Umfang beträgt damit 78,30 mm. Für dieses Beispiel berechnet sich die Breite des Spaltes 8 also zu 78,30 mm - 77,22 mm = 1,08 mm.

Das in dem Rohr 2 zur Verwendung kommende Material ist idealerweise so ausgelegt, daß bei dem Verengen des Spaltes 8 durch Schrumpfen keine oder eine nur sehr geringe plastische Verformung auftritt. Dies kann durch eine geeignete Wahl der Materialien mit entsprechenden Wanddicken erreicht werden.

**Patentansprüche**

1.   Supraleitfähiges elektrisches Kabel, welches mindestens einen supraleitfähigen, aus Bändern oder Drähten bestehenden Leiter (1) aufweist, die in mindestens einer Lage um einen als Rohr ausgeführten Träger (2) herumgewickelt sind, **dadurch gekennzeichnet, daß** das Rohr (2) in radialer Richtung mit veränderbarem Durchmesser elastisch verformbar ist und einen sich über seine ganze Länge erstreckenden, geradlinig entlang einer Mantellinie desselben verlaufenden Spalt (8) aufweist.

2.   Kabel nach Anspruch 1, **dadurch gekennzeichnet, daß** das Rohr (2) quer zu seiner Längsrichtung gewellt ist.

3.   Kabel nach Anspruch 1 oder 2, **dadurch gekennzeichnet, daß** das Rohr (2) aus Edelstahl besteht.

4.   Kabel nach Anspruch 1 oder 2, **dadurch gekennzeichnet, daß** das Rohr (2) aus Kupfer bzw. einer Kupferlegierung besteht.

**5.** Kabel nach Anspruch 4, **dadurch gekennzeichnet, daß** das Rohr (2) aus einer Beryllium-Kupfer-Legierung besteht.

**6.** Kabel nach Anspruch 1 oder 2, **dadurch gekennzeichnet, daß** das Rohr (2) aus Aluminium bzw. einer Aluminiumlegierung besteht.

**Claims**

**1.** Superconductive cable with at least one superconductive conductor (1) comprising ribbons or wiles which are wound within at least one layer around a tube (2) serving as a support for the conductor(1), **characterized in that** the tube (2) is elastically deformable in radial direction with a changing diameter and has on its whole length a longitudinally extending slot (8), which runs rectilinear along a surface line of the tub (2).

**2.** Cable according to claim 1, **characterized in that** the tube (2) is corrugated transverse to its longitudinal direction.

**3.** Cable according to claim 1 or 2, **characterized in that** the tube (2) is made from stainless steel.

**4.** Cable according to claim 1 or 2, **characterized in that** the tube (2) is made from copperora copperalloy.

**5.** Cable according to claim 4, **characterized in that** the tube (2) is made from a beryllium-copper-alloy.

**6.** Cable according to claim 1 or 2, **characterized in that** the tube (2) is made from aluminium or an aluminium alloy.

**Revendications**

**1.** Câble électrique supraconducteur qui présente au moins un conducteur supraconducteur (1) constitué de rubans ou de fils qui sont enroulés en au moins une couche autour d'un support (2) configuré comme tube,
**caractérisé en ce que**
le tube (2) est déformable élastiquement avec modification de son diamètre dans la direction radiale et présente un interstice (8) qui s'étend sur toute sa longueur, en ligne droite et le long d'une ligne d'enveloppe.

**2.** Câble selon la revendication 1, **caractérisé en ce que** le tube (2) est ondulé dans la direction transversale par rapport au sens de sa longueur.

**3.** Câble selon la revendication 1 ou 2, **caractérisé en ce que** le tube (2) est constitué d'acier allié.

**4.** Câble selon la revendication 1 ou 2, **caractérisé en ce que** le tube (2) est constitué de cuivre ou d'un alliage de cuivre.

**5.** Câble selon la revendication 4, **caractérisé en ce que** le tube (2) est constitué d'un alliage de béryllium et de cuivre.

**6.** Câble selon la revendication 1 ou 2, **caractérisé en ce que** le tube (2) est constitué d'aluminium ou d'un alliage d'aluminium.

Fig. 1

Fig. 2

Fig. 3

**IN DER BESCHREIBUNG AUFGEFÜHRTE DOKUMENTE**

**In der Beschreibung aufgeführte Patentdokumente**

- WO 03052775 A1
- EP 0650205 A1
- EP 1821380 B1